# EUROPÄISCHE PATENTSCHRIFT

(11) **EP 0 667 737 B1**
(45) Veröffentlichungstag und Bekanntmachung des Hinweises auf die Patenterteilung: **05.03.1997**
(21) Anmeldenummer: 95100680.8
(22) Anmeldetag: 19.01.1995
(51) Int. Cl.: H05K 7/20, H01L 23/433

(54) **Wärmeleitvorrichtung für elektrische Bauelemente**
Heat conductive device for electrical components
Dispositif conducteur de chaleur pour composants électriques

(30) Priorität: 09.02.1994 DE 4404035
(43) Veröffentlichungstag der Anmeldung: 16.08.1995
(73) Patentinhaber: Alcatel SEL Aktiengesellschaft, D-70435 Stuttgart (DE)
(72) Erfinder: Amberger, Reinhard, D-70499 Stuttgart (DE)
(74) Vertreter: Pohl, Herbert, Dipl.-Ing

(56) Entgegenhaltungen:
- EP-A- 0 167 033
- EP-A- 0 288 183
- DE-A- 3 103 857
- DE-A- 3 738 897
- DE-A- 4 106 185
- DE-U- 8 714 174
- IBM DISCLOSURE BULLETIN, Bd. 20 ,Nr. 7, Dezember 1977 New York,US; Seiten 2707-2708, V.W. ANTONETTI:'Swivel piston conduction module'
- IBM DISCLOSURE BULLETIN, Bd. 23,Nr. 3, August 1980 New York,US; Seiten 1123-1124, R.C. CHU:'Force-free solid thermal conduction module'

## Beschreibung

Die Erfindung betrifft eine Vorrichtung zur Wärmeableitung für elektrische Bauelemente nach dem Oberbegriff des Anspruchs 1.

Eine derartige Vorrichtung ist aus der DE 37 38 897 C2 bekannt. Zum Abführen von in integrierten Schaltungen und dgl. erzeugter Verlustwärme werden häufig Verbindungselemente benutzt, die als starres Metallstück ausgebildet sind und die Verbindung mit größeren Kühlplatten oder mit der Frontplatte bei Baugruppen herstellen, die als Wärmesenke dienen. Sobald sich aber z.B. die Leiterplatte, auf der das Bauelement befestigt ist, verzieht, kann sich die Wärmeabfuhr erheblich verschlechtern. Um diesen Effekt zu vermeiden, werden elastische Verbindungselemente eingesetzt. Das beschriebene Verbindungselement wird aus einem metallischen dünnen Folienband hergestellt, das durchgehend auf einen Dorn aufgewickelt und danach mit einem Stempel geprägt wird. Dabei werden die Folienbandlagen aufeinandergedrückt, so daß sich ein flacher Wärmeleitstreifen bildet, der in seinem mittleren Bereich nachgiebig ist. Die beiden auf dem Bauelement und auf einer Wärmesenke zu befestigenden Endbereiche werden durch metallische Druckstücke versteift, die gleichzeitig zur Befestigung dienen. Auf das Bauelement wird einer der beiden Endbereiche geklebt oder mit einer metallischen Klammer befestigt.

Ferner ist aus der EP 0 167 033 A2 eine Vorrichtung zur Wärmeableitung bekannt, bei der ein Wärme erzeugendes, elektrisches Bauelement in Form eines Halbleiterchips, der auf einem Substrat oder einer Leiterplatte befestigt ist, auf seiner Oberseite von der Unterseite eines kegelstumpfförmigen Bauteils kontaktiert wird. Das Bauteil ist mit seinem Konus in einer entsprechenden Vertiefung in einem Kühlkörper eingelassen und wird durch eine dazwischen eingefügte Druckfeder gegen das elektrische Bauelement gedrückt. Außerdem soll der Wärmeübergang und die mechanische Flexibilität an den konischen Flächen durch eine gut wärmeleitende Fettschicht, an der Basisfläche durch eine Schicht einer gut wärmeleitenden, niedrigschmelzenden Legierung verbessert werden.

Andere Vorrichtungen dieser Art sind aus der EP 0 288 183 A2 bekannt, wobei die Bauteile und die Vertiefungen in den Kühlkörpern halbzylindrisch, prismatisch oder pyramidenförmig sind. Außerdem sind die Bauteile vorzugsweise durch senkrechte Trennebenen halbiert oder, im Fall der Pyramide, sogar geviertelt. Dazwischengefügte Druckfedern drücken die Kontaktflächen der Bauteile einerseits und der Bauelemente und der Kühlkörper andererseits gegeneinander, um den Wärmeübergang zu verbessern. Da sich die Bauteile gut an die Flächen des Bauelementes und des Kühlkörpers anlegen sollen, andererseits aber die Reibung gering sein muß, um diesen Effekt auch bei Verkantung zu erreichen, sind als Kompromiß die Berührungsflächen von Bauteil und Kühlkörper unterschiedlich gekrümmt, was sich jedoch wiederum nachteilig auf den Wärmeübergang auswirkt.

Der Erfindung liegt die Aufgabe zugrunde, eine andere Vorrichtung der eingangs genannten Art zu schaffen, die einen guten Wärmeübergang von einem elektrischen Bauelement auf eine Wärmesenke sicherstellt. Gelöst wird diese Aufgabe durch die im Anspruch 1 angegebenen Merkmale. Vorteilhafte Weiterbildungen sind den Unteransprüchen zu entnehmen.

Die Erfindung wird anhand von Ausführungsbeispielen beschrieben, die in der zugehörigen Zeichnung dargestellt sind. Darin zeigen:
- Fig. 1a: eine Vorrichtung zur Wärmeableitung von einem auf eine Leiterplatte gelöteten Schaltkreis zu einer mit der Leiterplatte verbundenen Frontplatte, bestehend aus einem Adapterteil, einem Befestigungsteil und einem verbindenden Gummiformteil, in Seitenansicht, teilweise geschnitten;
- Fig. 1b: die Vorrichtung nach Fig. 1a, jedoch in Vorderansicht, ohne Frontplatte;
- Fig. 2: eine ähnliche Ausführung wie in Fig. 1a, jedoch mit anderem Gummiformteil, in Seitenansicht, teilweise geschnitten;
- Fig. 3: eine weitere Ausführung der Vorrichtung, jedoch mit anderen konischen Wärmekontaktansätzen an Adapter- und Befestigungsteil, in Seitenansicht, teilweise geschnitten, und
- Fig. 4: eine ähnliche Ausführung der Vorrichtung wie Fig. 3, jedoch mit zylindrischen Wärmekontaktflächen an Adapter- und Befestigungsteil, in Seitenansicht, teilweise geschnitten.

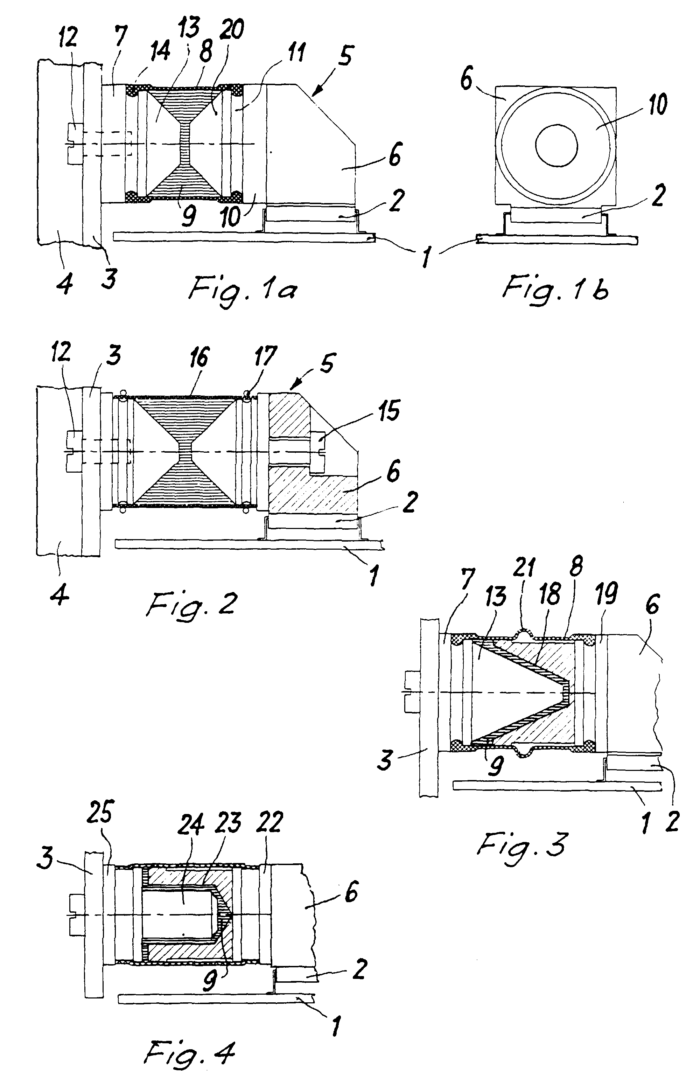

Bei der in Fig. 1a und 1b dargestellten Ausführung ist auf die Leiterplatte 1 einer Leiterplatten-Baugruppe ein Verlustwärme abgebendes, elektrisches Bauelement 2, z.B. in Form eines Halbleiterchips bzw. einer integrierten Schaltung, gelötet. Die Leiterplatte 1 ist mit einer senkrecht zu ihr stehenden Frontplatte 3 verbunden, die vorzugsweise aus Metall hergestellt ist und mit Kühlrippen 4 ausgerüstet sein kann.

Zur Ableitung der Verlustwärme des Bauelementes 2 dient eine Vorrichtung 5, die aus einem Adapterteil 6, einem Befestigungsteil 7, einem Gummiformteil 8 sowie einer Füllmasse 9 besteht.

Das Adapterteil 6 ist ein quaderförmiger Metallkörper, dessen Grundfläche dem Bauelement 2 angepaßt ist und mit diesem z.B. mittels eines gut wärmeleitenden Klebstoffs verbunden wird, um einen möglichst guten thermischen Kontakt zu erzielen. Rechtwinklig zu dieser Grundfläche ist an einer anderen Seite des Adapterteils 6 ein Ansatz 10 mit einem Kegelstumpf 20 angebracht. Dieser Teil kann an das Adapterteil 6 angeformt oder, wie in Fig. 2 dargestellt, separat gefertigt und mit einer Schraube 15 befestigt sein. Der Kegelstumpf 20 ist mit einer hinterschnittenen Rille 11 versehen, die zur Befestigung des Gummiformteiles 8 dient.

Das Befestigungsteil 7 gleicht in seiner Form dem zuvor genannten Ansatz 10. In seiner Grundfläche enthält es eine konzentrische Gewindebohrung, so daß es mittels einer Schraube 12 an der Frontplatte 3 montiert werden kann.

Besteht das Adapterteil 6, wie erwähnt, aus zwei Teilen (Fig. 2), so kann für seinen Ansatz 10 ein mit dem Befestigungsteil 7 identisches Teil verwendet werden.

Das Gummiformteil 8 verbindet den Ansatz 6 mit dem Befestigungsteil 7, wobei deren Kegelstümpfe 20 und 13 gegeneinander gerichtet sind. Das Gummiformteil 8 ist ein Stück Rohr bzw. Schlauch mit einwärts gerichteten Verdickungen oder Wülsten 14 an beiden Enden, mit denen es beim Aufschieben in die Rille 11 von Ansatz 10 und Befestigungsteil 7 gedrückt wird. Der verbleibende Hohlraum innerhalb des Gummiformteiles 8 wird bei der Montage mit einem wärmeleitenden Medium 9 gefüllt, z.B. einer Mischung aus Wärmeleitöl mit Aluminium- oder Kupferpulver.

Die Ausführung nach Fig. 2 entspricht im wesentlichen der zuvor beschriebenen, nur wird für das Gummiformteil 16 ein einfaches Schlauchstück ohne Wülste verwendet. Seine Befestigung auf dem Ansatz 10 und dem Befestigungsteil 7 erfolgt mittels zweier Spannringe 17, die an den Stellen der Rillen 11 über den Schlauch gespannt werden und den Gummi in die Rillen drücken.

Bei der Ausführung nach Fig. 3 steht dem Kegelstumpf 13 des Befestigungsteiles 7 eine entsprechende Vertiefung 18 in einem zylindrischen Ansatz 19 des Adapterteiles 6 gegenüber, wobei der Kegelstumpf nur soweit in die Vertiefung eingreift, daß sich die Teile nicht berühren. Im Zwischenraum befindet sich, wie zuvor, eine wärmeleitendes Medium 9. In den übrigen Einzelheiten entspricht die Vorrichtung den bereits beschriebenen Ausführungen. Das Gummiformteil 8 ist zusätzlich mit einer Balgfalte 21 versehen, die die Bewegbarkeit der Teile erhöht.

Die in Fig. 4 gezeigte Ausführung ist der in Fig. 3 abgebildeten ähnlich, jedoch unterscheidet sie sich durch eine zylindrische Gestaltung der ineinander greifenden Teile von Adapterteil 6 und Befestigungsteil 25 anstelle der kegelstumpfförmigen Ausbildung. Im Ansatz 22 des Adapterteiles 6 ist eine zylindrische Bohrung 23 angebracht, in die ein zylindrischer Zapfen 24 geringeren Durchmessers hineinragt, der am Befestigungsteil 25 angesetzt ist. Die Zwischenräume sind wiederum mit dem wärmeleitenden Medium 9 angefüllt.

Zu allen Ausführungen ist noch zu bemerken, daß die Oberflächen der Kegelstümpfe (13, 18, 20) oder Zylinder (23, 24) sehr rauh sein soll, um möglichst große Wärmeübergangsflächen zu schaffen. Durch die elastische Verbindung von Adapter- und Befestigungsteil bleibt der gute Wärmeübergang auch dann erhalten, wenn sich die Lage des zu kühlenden Bauelements und der Wärmesenke relativ zueinander verändern, z.B. durch Wärmeeinwirkung. Außerdem ist von Vorteil, daß bei der Herstellung und Montage der Teile keine engen Toleranzen erforderlich sind und demzufolge auch die Kosten niedrig gehalten werden können.

## Patentansprüche

1. Vorrichtung zur Wärmeableitung für elektrische Bauelemente der Nachrichtentechnik, die eine elastische Verbindung zwischen Bauelement und einer Wärmesenke bildet und mit beiden in innigem, thermischem Kontakt steht,
**dadurch gekennzeichnet,** daß die Vorrichtung (5) aus einem mit der Wärmesenke (3) verbindbaren Befestigungsteil (7, 25), einem das Bauelement (2) kontaktierendem Adapterteil (6) mit einem auf das Befestigungsteil (7, 25) gerichteten Ansatz (10, 19, 22) und einem, das Befestigungsteil mit dem Ansatz verbindenden, schlauchartigen Gummiformteil (8, 16) besteht, das über gegeneinander gerichtete Teile (13, 18, 20, 23, 24) des Befestigungsteiles (7, 25) und des Ansatzes (10, 19, 22) gezogen ist, wobei verbleibende Hohlräume in seinem Inneren mit einem wärmeleitenden Medium (9) gefüllt sind.

2. Vorrichtung nach Anspruch 1, dadurch gekennzeichnet, daß die gegeneinander gerichteten Teile (13, 18, 20, 23, 24) von Befestigungsteil (7, 25) und Ansatz (10, 19, 22) eine stark aufgerauhte Oberfläche besitzen.

3. Vorrichtung nach Anspruch 2, dadurch gekennzeichnet, daß die gegeneinander gerichteten Teile von Befestigungsteil (7) und Ansatz (10) erhabene Kegelstümpfe (13, 20) sind.

4. Vorrichtung nach Anspruch 2, dadurch gekennzeichnet, daß die gegeneinander gerichteten Teile von Befestigungsteil (7) und Ansatz (19) von einem Kegelstumpf (13) und einer kegelstumpfförmigen Vertiefung (18) gebildet werden, die berührungslos ineinander greifen.

5. Vorrichtung nach Anspruch 2, dadurch gekennzeichnet, daß die gegeneinander gerichteten Teile von Befestigungsteil (25) und Ansatz (22) ein zylindrischer Zapfen (24) und eine entsprechende Vertiefung (23) sind, die berührungslos ineinander greifen.

6. Vorrichtung nach Anspruch 3, 4 oder 5, dadurch gekennzeichnet, daß die gegeneinander gerichteten Teile von Befestigungsteil (7) und Ansatz (10, 19) je eine hinterschnittene Rille (11) aufweisen.

7. Vorrichtung nach Anspruch 6, dadurch gekennzeichnet, daß das Gummiformteil (8) an beiden Enden je eine Wulst (14) hat, die in jeweils eine der Rillen (11) einfügbar ist.

8. Vorrichtung nach Anspruch 6, dadurch gekennzeichnet, daß das Gummiformteil (8) an beiden Enden durch Spannringe (17) in den Rillen (11) gehalten wird.

9. Vorrichtung nach einem der vorhergehenden Ansprüche, dadurch gekennzeichnet, daß das Adapterteil (6) aus einem im wesentlichen quaderförmigen Block und einem angeschraubten Ansatz (10, 19, 22) besteht.

## Claims

1. Device for heat dissipation for electrical components in communications technology, which forms a flexible connection between component and a heat sink and is in intimate thermal contact with both, characterized in that the device (5) comprises a fixing part (7, 25) which can be connected to the heat sink (3), an adapter part (6) contacting the component (2) with an extension (10, 19, 22) directed towards the fixing part (7, 25) and a hose-like rubber moulded part (8, 16) connecting the fixing part to the extension, which rubber moulded part is drawn over parts directed towards each other (13, 18, 20, 23, 24) of the fixing part (7, 25) and of the extension (10, 19, 22), wherein remaining cavities in its interior are filled with a heat-conducting medium (9).

2. Device according to Claim 1, characterized in that the parts directed towards each other (13, 18, 20, 23, 24) of fixing part (7, 25) and extension (10, 19, 22) have an extremely roughened surface.

3. Device according to Claim 2, characterized in that the parts directed towards each other of fixing part (7) and extension (10) are raised truncated cones (13, 20).

4. Device according to Claim 2, characterized in that the parts directed towards each other of fixing part (7) and extension (19) are formed by a truncated cone (13) and a truncated-cone-shaped depression (18) which engage without touching.

5. Device according to Claim 2, characterized in that the parts directed towards each other of fixing part (25) and extension (22) are a cylindrical pin (24) and a corresponding depression (23) which engage without touching.

6. Device according to Claim 3, 4 or 5, characterized in that the parts directed towards each other of fixing part (7) and extension (10, 19) each have an undercut groove (11).

7. Device according to Claim 6, characterized in that at both ends the rubber moulded part (8) has a bead (14) each of which can be inserted into one of the grooves (11).

8. Device according to Claim 6, characterized in that the rubber moulded part (8) is held in the grooves (11) at both ends by clamping rings (17).

9. Device according to one of the preceding Claims, characterized in that the adapter part (6) comprises a substantially rectangular parallelepiped-shaped block and a screwed-on extension (10, 19, 22).

## Revendications

1. Dispositif pour l'évacuation de chaleur pour les composants électriques utilisés en technique de communication, permettant un assemblage souple du composant et du puits thermique et établissant un contact thermique étroit entre les deux,
caractérisé par le fait que le dispositif (5) est composé d'une pièce de fixation (7, 25) que l'on peut relier à un puits thermique (3), d'une pièce adaptatrice (6) mise en contact avec un composant (2), d'un épaulement (10, 19, 22) orienté vers la pièce de fixation (7, 25), et d'une pièce en caoutchouc (8, 16) de type tuyau reliant la pièce de fixation et l'épaulement, par l'intermédiaire des parties (13, 18, 20, 23, 24) de la pièce de fixation (7, 25) et de l'épaulement (10, 19, 22), qu'elle recouvre. L'espace vide restant à l'intérieur du dispositif sera rempli avec un produit conducteur de chaleur (9).

2. Dispositif, suivant la revendication 1, caractérisé par le fait que les pièces opposées les unes par rapport aux autres (13, 18, 20, 23, 24) de la pièce de fixation (7, 25) et de l'épaulement (10, 19, 22) possèdent une surface rugueuse.

3. Dispositif, suivant la revendication 2, caractérisé par le fait que les pièces opposées les unes par rapport aux autres de la pièce de fixation (7) et de l'épaulement (10) ont une forme tronconique (13, 20).

4. Dispositif, suivant la revendication 2, caractérisé par le fait que les pièces opposées les unes par rapport aux autres de la pièce de fixation (7) et de l'épaulement (19) possèdent un cône tronqué (13) et un creux de forme tronconique (18), qui s'encastrent l'un dans l'autre sans contact.

5. Dispositif, suivant la revendication 2, caractérisé par le fait que les pièces opposées les unes par rapport aux autres de la pièce de fixation (25) et de l'épaulement (22) possèdent un prolongement cylindrique (24) et un creux de forme correspondante (23), qui s'encastrent l'un dans l'autre sans contact.

6. Dispositif, suivant les revendications 3, 4 ou 5, caractérisé par le fait que les pièces opposées les unes par rapport aux autres de la pièce de fixation (7) et de l'épaulement (10, 19) présentent chacune une gorge (11).

7. Dispositif, suivant la revendication 6, caractérisé par le fait que la pièce en caoutchouc (8) possède une nervure (14) à chaque extrémité, s'insérant dans chacune des gorges (11).

8. Dispositif, suivant la revendication 6, caractérisé par le fait que la pièce en caoutchouc (8) est maintenue dans les gorges (11) à chaque extrémité par un anneau de serrage (17).

9. Dispositif, suivant l'une quelconque des revendications, caractérisé par le fait que la pièce adaptatrice (6) consiste en un bloc rectangulaire et un épaulement vissé sur celui-ci (10, 19, 22).
